# EUROPÄISCHE PATENTSCHRIFT

(11) **EP 3 218 966 B1**
(45) Veröffentlichungstag und Bekanntmachung des Hinweises auf die Patenterteilung: **08.04.2020**
(21) Anmeldenummer: 14796528.9
(22) Anmeldetag: 13.11.2014
(51) Int. Cl.: H05K 1/02, H05K 1/14, H01R 12/52, H01R 13/11, H05K 3/36

(54) **VORRICHTUNG ZUR LEISTUNGSKONTAKTIERUNG**
AFFRANGEMENT FOR POWER CONNECTION
AGENCEMENT POUR CONNECTION DE PUISSANCE

(43) Veröffentlichungstag der Anmeldung: 20.09.2017
(73) Patentinhaber: Leukert GmbH, 87600 Kaufbeuren-Neugablonz (DE)
(72) Erfinder: MÜLLER, Matthias, 86825 Bad Wörishofen (DE); KOLB, Rudi, 87629 Füssen-Hopfen (DE)
(74) Vertreter: Hoppe, Lars
(86) Internationale Anmeldenummer: PCT/EP2014/074504
(87) Internationale Veröffentlichungsnummer: WO 2016/074729

(56) Entgegenhaltungen:
- EP-A2- 1 379 113
- DE-A1- 4 006 078
- FR-A1- 2 565 425
- FR-A1- 2 906 436
- US-A- 2 756 485
- US-A1- 2008 144 301

## Beschreibung

Die vorliegende Erfindung betrifft eine Vorrichtung zur Leistungskontaktierung, unter anderem für Leiterplatten.

Im Bereich der Leistungskontaktierung von insbesondere miteinander verbundenen Leiterplatten oder Leiterplattenstapeln oder Stromschienen oder anderen, höhere Ströme führenden Bauteilen treten oftmals Ströme von zum Teil deutlich mehr als 100 A auf, wobei derartige Leiterplatten oder Stromschienen beispielsweise im Bereich der Elektromotoren, Batterien, Akkumulatoren oder allgemein im Bereich der Verbindung von Leistungsabnehmern und Quellen elektrischer Energie eingesetzt werden. Gerade im Bereich der Elektromobilität werden sehr hohe Ladeströme benötigt und erfordern entsprechend dimensionierte und alltagstaugliche Leistungskontakte.

Die bekannten Vorrichtungen zur Leistungskontaktierung von insbesondere Leiterplatten oder Leiterplattenstapeln zwischen beispielsweise Akkumulatoren und Leistungsabnehmern weisen regelmäßig die Leiterplatten im Betriebszustand durchsetzende Kontaktstifte auf, wobei die Kontaktstifte jeweils in einer Aufnahme der Leiterplatte geführt sind. Diese Aufnahme ist oftmals mit einem federnden Ring oder allgemeiner mit federnden Kontakten zum dauerhaften sicheren Kontaktieren des Kontaktstiftes versehen. Derartige Kontaktstifte sind üblicherweise aus Metall und im Querschnitt rund ausgebildet.

In Bauteilen, in denen sich die Leiterplatten oder Leiterplattenstapel im Betriebszustand relativ zueinander bewegen, beispielsweise aufgrund unterschiedlicher Erwärmung, kann die sichere Kontaktierung von Kontaktstift zu Bauteil nicht mehr für jeden Betriebszustand sichergestellt werden. Beispielsweise können sich die Leiterplatten so verschieben, dass die Federkontakte der Aufnahmen nicht mehr vollumfänglich am Kontaktstift anliegen.

Die US 2008/144301 A1 offenbart eine Vorrichtung zur Kontaktierung einer Platine mit einer ersten Führung, die an der Platine festgelegt ist und in der eine zweite Führung angeordnet, die in die erste eingeschoben wird und die im Betriebszustand von einem Kontaktstift durchsetzt ist, wobei beide Führungen nach dem Einsetzen aneinander festgelegt sind.

Es ist daher Aufgabe der Erfindung, einen Leistungskontakt anzugeben, der auch bei relativer Bewegung der kontaktierten Bauteile zu dem Kontaktstift eine hochwertige Kontaktierung dauerhaft sicherstellt.

Diese Aufgabe wird bei einer Vorrichtung zur Leistungskontaktierung, aufweisend einen Kontaktstift und mindestens eine von diesem im Betriebszustand durchsetzte Kontaktstiftaufnahme wobei_die Kontaktstiftaufnahme eine, im Betriebszustand an einem Bauteil festgelegte, erste Führung und eine, leitend mit der ersten verbundene, zweite Führung aufweist, wobei die zweite Führung verschieblich an der ersten Führung angeordnet ist und wobei der Kontaktstift im Betriebszustand mindestens die zweite Führung leitend kontaktierend ist, sowie durch die weiteren Merkmale des Anspruches 1.

Durch die erfindungsgemäße Verschiebbarkeit der beiden Führungsteile zueinander wird mit großem Vorteil eine Taumelbewegung der Längsachse des wenigstens eine, vorzugsweise beide der Führungen durchsetzenden Kontaktstiftes ermöglicht, wie sie durch sich bewegende Bauteile relativ zum Kontaktstift verursacht wird. Das erfindungsgemäße Vorsehen eines intrinsischen Beweglichmachens der Führung erlaubt mit sehr großem Vorteil auch eine Bewegung des Kontaktstiftes innerhalb der Führung, bzw. eine Bewegen der Führung relativ zum Kontaktstift, der dieser Bewegung dann ohne Kontaktierungsverlust folgen kann. Mit großem Vorteil wird von der Erfindung die mechanisch einfache Lösung einer Verschiebbarkeit zweier Teile zueinander gewählt anstelle komplexerer Lösungen, die eine kardanische Aufhängung oder dergleichen erfordern. Bevorzugt ist dabei, dass die zweite Führung an der, insbesondere in der, ersten Führung geführt und von dieser gehaltert ist.

Erfindungsgemäß ist weiter vorgesehen, dass die erste und die zweite Führung jeweils eine zentrale Öffnung aufweisen, die im Betriebszustand jeweils von dem Kontaktstift durchsetzt sind. Unter zentralen Öffnungen werden erfindungsgemäß auch solche Öffnungen verstanden, die nicht in der geometrischen Mitte einer Führung liegen, also auch außermittige. Öffnung im Sinne der Erfindung sind in jedem Fall Durchgangsöffnungen, die zudem eine runde, eckige oder polygone Form der Durchgangsfläche haben können. Beide Öffnungen werden vom Kontaktstift durchsetzt und sind daher an dessen Längsachse gesehen voneinander beabstandet. Die beiden Öffnungen liegen daher nur in Richtung der Längsachse des Kontaktstiftes gesehen koaxial zueinander, im Bezugssystem des Bauteiles können diese in jeder Richtung davon abweichen.

Schließlich ist erfindungsgemäß noch vorgesehen, dass erste und zweite Führung zueinander korrespondierend ausgebildete Eingriffsmittel aufweisen. Diese Maßnahme stellt sicher, dass die beiden Führungen aneinander sicher geführt sind und somit stets in der Lage sind, den vom Kontaktstift in die zweite Führung eintretenden Strom an die erste Führung und an das Bauteil weiterzugeben oder umgekehrt. Der Erfindung ist es also wichtig, die zweite Führung nicht nur passiv in einem Hohlraum der ersten Führung aufzunehmen, sondern diese körperlich aneinander anzupassen und mit aufeinander abgestimmten und miteinander wechselwirkenden Eingriffsmitteln zu versehen.

In Weiterbildung der Erfindung ist vorgesehen, dass die Eingriffsmittel der ersten Führung als eine oder mehrere, insbesondere drei, radial auswärts liegende Öffnungen ausgebildet sind, vorzugsweise umfänglich gleichbeabstandete Öffnungen, und/oder als Sicken im Bereich zwischen den radial auswärtigen Öffnungen und/oder als Umgriffe. Die erstgenannte Ausgestaltung erlaubt durch das Vorsehen einfacher Aussparungen in der Hauptfläche der ersten Führung, die beispielsweise einfach durch Stanzen herstellbar sind, ein konstruktiv einfaches Eingriffsmittel. Diese Öffnungen, von denen mindestens eine, jedoch auch zwei, drei, vier, fünf oder mehr vorhanden sein können, können von korrespondierenden Eingriffsmitteln der zweiten Führung durchsetzt, umgriffen oder sonst wie kontaktiert werden. Der Fachmann wird diejenige Anzahl und Orientierung von Öffnungen wählen, die eine ausreichende Beweglichkeit bei gleichzeitig verbleibender ausreichender Kontaktfläche zwischen erster und zweiter Führung sicherstellen. Mit Vorteil erlaubt die umfängliche Gleichbeabstandung und damit die symmetrische Anordnung eine an allen Umfangspunkten der Führung gleich gute flächige Kontaktierung, d.h. in der gesamten Fläche der ersten Führung stehen umfänglich ausreichend Kontaktflächen für die zweite Führung zur Verfügung. Die zusätzliche oder alternative Ausgestaltung der Eingriffsmittel als im Bereich zwischen den radial auswärtigen Öffnungen vorgesehenen Sicken erlauben eine noch bessere Kontaktierung zwischen erster und zweiter Führung, da so zusätzlich zu einer flächigen auch eine formschlüssige Kontaktierung ermöglicht wird. Die additive oder alternative Ausgestaltung der Eingriffsmittel als Umgriffe stellt eine weitere formschlüssige Verbindungsmöglichkeit zwischen erster und zweiter Führung zur Verfügung, indem die Umgriffe entsprechend geformte Teile der zweiten Führung umgreifen. Die Eingriffsmittel sollen erfindungsgemäß also miteinander so formschlüssig und/oder kraftschlüssig sein, dass sie eine Relativbewegung der beiden Führungen zueinander in gewissen Grenzen ermöglichen, vor allem eine in zwei Richtungen verschiebliche Relativbewegung, also in einer Ebene. Weiterhin ermöglichen sie dabei eine ausreichend große Kontaktfläche zur Stromleitung.

In Ausgestaltung der Erfindung ist vorgesehen, dass die erste Führung als Kreisscheibe mit einem zur Scheibenebene gewinkelten Rand ausgebildet ist, insbesondere mit einer Mehrzahl vom Rand radial auswärts gerichteten und zur Ebene der Kreisscheibe überwiegend parallel orientierten Befestigungslaschen ausgebildet ist. Eine solche Scheibe ist als Stanzteil leicht herzustellen und weist aufgrund des runden Umfanges keine scharfen Ecken oder Kanten auf, die zum einen grundsätzlich eine höhere Verletzungsgefahr darstellen als auch für die Stromleitung ungünstig sind. Durch das Umbiegen des Randes, beispielsweise durch Tiefziehen, entsteht ein Aufnahmeraum für die zweite Führung, der deren Beweglichkeit erst grundsätzlich ermöglicht. Die radial auswärts weisenden Befestigungslaschen dienen zur Befestigung oder Festlegung der ersten Führung an einem Bauteil, beispielsweise einer Leiterplatte oder ähnlichem. Diese Festlegung kann erfindungsgemäß per Löten im reflow erfolgen, also bei der Passage einer Leiterplatte durch einen Lötofen. Hierdurch ist die erfindungsgemäße Führung auch wieder entformbar, also trennbar von der Leiterplatte, was das spätere Recycling verbrauchter Leiterplatten erleichtert. Durch die Parallelität der von den Befestigungslaschen aufgespannten Ebene und der Ebene der Kreisscheibe wird mit Vorteil ein etwa zylinderscheibenartiger Hohlraum zwischen Leiterplatte und erster Führung geschaffen, in den die zweite Führung beweglich aufgenommen wird und der auch bei temperaturbedingter Ausdehnung der beiden Führungen stets ausreichend Bewegungsraum zur Verfügung stellt. Obwohl grundsätzlich eine überwiegend runde Ausgestaltung der ersten Führung bevorzugt ist, kann diese auch in anderen geometrischen Formen ausgebildet sein, beispielsweise als Polygon.

Im Hinblick auf die zweite Führung schlägt die Erfindung vor, dass diese eine Mehrzahl, zu einem Zentrum der zentralen Öffnung gerichteter Federkontaktarme aufweist und das die zentrale Öffnung kleiner als die zentrale Öffnung der ersten Führung ausgebildet ist. Hierdurch wird mit Vorteil sichergestellt, dass die Federkontaktarme einen die zweite zentrale Öffnung durchsetzenden Kontaktstift vollumfänglich kontaktieren, und die zweite Führung mit einem kontaktierten Kontaktstift in ihrer zentralen Öffnung eine Bewegung innerhalb der größeren, ersten zentralen Öffnung der ersten Führung ausführen kann. Die Federkontaktarme können und sollen dabei aus der Ebene der Hauptfläche der zweiten Führung hinausweisen und im Betriebszustand durch die zentrale Öffnung der ersten Führung hindurch weisen diese also wie der Kontaktstift durchsetzen. Hierdurch wird ein weiteres Eingriffsmittel gebildet.

Bezüglich der zweiten Führung ist erfindungsgemäß weiter vorgesehen, dass ihre Eingriffsmittel als eine zur Zahl der radial auswärtigen Öffnungen der ersten Führung in Zahl und Form korrespondierende Eingriffsnasen ausgebildet sind, insbesondere am radial auswärtigen Rand der zweiten Führung und/oder als zum Eingriff in die Sicken der ersten Führung korrespondierend geformte und angeordnete Sicken ausgebildet sind und/oder als Federelemente, wobei auch die Eingriffsnasen als Federelemente ausgebildet sein können oder sind. Die Eingriffsnasen sind dabei vorzugsweise als Stege ausgebildet, deren Verlauf in etwa mit gleichbleibendem Radius ist, sie sind also als zur Kreisscheibe der zweiten Führung umfänglich verlaufend orientiert und stellen damit entlang ihrer Längsausdehnung einen Verstellweg zur Verfügung. Durch die Anordnung der Eingriffsnasen am Rande der Hauptfläche der zweiten Führung in einer Ausnehmung sind diese maximal voneinander beabstandet und stellen damit eine bestmögliche Kontaktierung der beiden Führungen sicher, da sie die gesamte Flächenausdehnung der zweiten Führung abdecken. Das erfindungsgemäße Vorsehen von Sicken, die zum Eingriff in die Sicken der ersten Führung korrespondierend geformt und angeordnet sind, ermöglicht eine weitere formschlüssige Verbindung zwischen den Führungen und damit ein noch sichereres Kontaktieren. Erfindungsgemäß ist auch, wenn die Sicken der ersten Führung zum Eingriff durch die Eingriffsnasen der zweiten Führung ausgebildet sind. Sind die Eingriffselemente additiv oder alternativ als Federelemente ausgebildet, so können diese in entsprechend geformten Aufnahmen der ersten Führung aufgenommen und dort auch kraftschlüssig gehaltert werden. Auch in diesem Fall sind die Federelemente in den Randbereichen der zweiten Führung angeordnet, um eine möglichst große Hauptfläche abzudecken.

In Ausgestaltung der Erfindung ist vorgesehen, dass die Eingriffsnasen einen Umgriff für die Bereiche der ersten Führung bildend sind und hierbei durch die radial äußeren Öffnungen hindurchtreten. Unter Umgriff versteht die Erfindung dabei eine vorzugweise überwiegend parallele Beabstandung von Kreisebene der zweiten Führung zur Ebene, die durch die Eingriffsnase aufgespannt werden. Mit anderen Worten beginnen die Eingriffsnasen in der Ebene der Kreisscheibe und verlaufen dann dazu gewinkelt, bis sie einen ausreichenden Abstand erreicht haben, um zwischen sich und der Ebene der Kreisscheibe der zweiten Führung die Wandstärke der Kreisscheibe der ersten Führung aufzunehmen. Sobald dieser Abstand erreicht ist, verlaufen die Eingriffsnasen wieder in einer zur Ebene der Kreisscheibe der zweiten Führung parallelen Ebene.

Wie bereits ausgeführt, ist erfindungsgemäß vorgesehen, dass die zweite Führung als Kreisscheibe ausgebildet ist, insbesondere als im Vergleich zur ersten Führung radial kürzere Kreisscheibe, wobei insbesondere eine Dicke der Kreisscheibe geringer ist als eine Höhe des gewinkelten Randes der ersten Führung. Unter radial kürzer versteht die Erfindung, dass die zweite Kreisscheibe einen kleineren Radius als die erste Kreisscheibe aufweist, also auch flächenkleiner ist. Dadurch, dass der umgebogene Rand der ersten Führung größer ist als die Dicke der Kreisscheibe der zweiten Führung, kann diese im so aufgespannten Raum problemlos bewegt werden.

Wie bereits erwähnt, können erfindungsgemäß erste und zweite Führung auch als überwiegend rechteckige Platten ausgebildet sein. Die Form der beiden Führungen ist lediglich aufeinander abzustimmen, so dass die Funktionalität erhalten bleibt, also die zweite Führung relativ zur ersten verschieblich und an dieser geführt ist, oder anders beide sich gegenseitig führen.

Schließlich ist vorgesehen, dass die zweite Führung in der ersten Führung eine horizontal verschiebliche Bewegbarkeit aufweist, wobei die maximalen Auslenkungen der zweiten Führung einem radialen Längenunterschied von radialer Ausdehnung der auswärts liegende Öffnungen und einer radialen Breite der Eingriffsnasen entsprechend sind. Mit anderen Worten ist die maximale Auslenkung der zweiten zur ersten Führung durch die geometrischen Verhältnisse beider Führungen zueinander festgelegt, insbesondere von Längenunterschieden. Diese Verschiebbarkeit bedingt die Ermöglichung einer Taumelbewegung des beide Führungen durchsetzenden Kontaktstiftes und gibt diesem damit ausreichend Bewegungsfreiheitsgrade zum Kompensieren der Lageveränderung der kontaktierten Bauteile.

Die Erfindung wird in einer bevorzugten Ausführungsform unter Bezugnahme auf eine Zeichnung beispielhaft beschrieben, wobei weitere vorteilhafte Einzelheiten den Figuren der Zeichnung zu entnehmen sind.

Funktionsmäßig gleiche Teile sind dabei mit denselben Bezugszeichen versehen.

Die Figuren der Zeichnung zeigen im Einzelnen:
- Fig. 1:: eine perspektivische Ansicht einer ersten Ausführungsform,
- Fig. 2:: eine Detailansicht der zweiten Führung dieser Ausführungsform,
- Fig. 3:: eine perspektivische Ansicht der Ausführungsform in Einbaulage und
- Fig. 4:: eine zweite Ausführungsform der Erfindung.

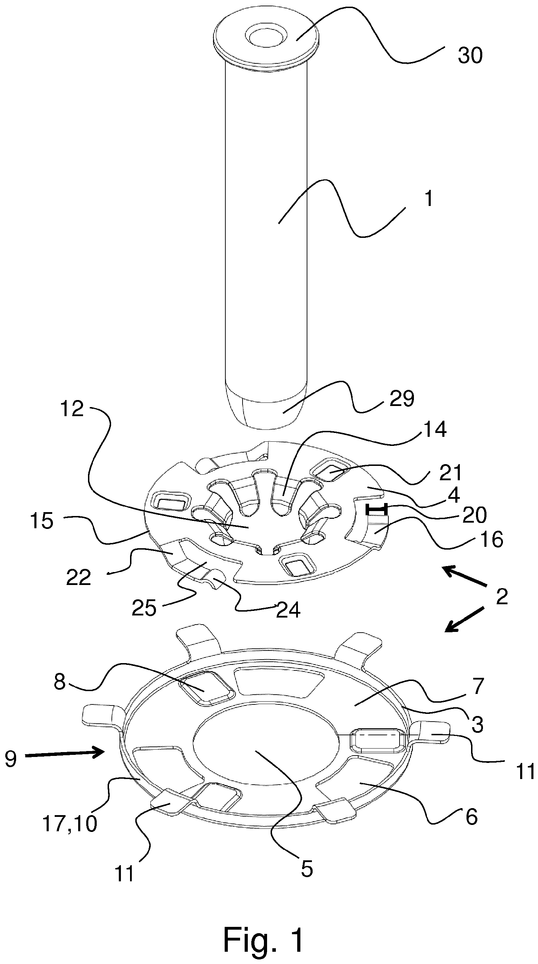

**Fig. 1** zeigt in perspektivischer Ansicht einen Kontaktstift 1, eine zweite Führung 4 und eine erste Führung 3, die zusammen eine Kontaktstiftaufnahme 2 bilden.

Der Kontaktstift 1 ist ein längliches rotationssymmetrisches Teil mit einer Einlaufschräge 29 und einer dazu entgegengesetzt angeordneten Andruckfläche 30. Er wird in Einbaulage von einem Leiter elektrisch kontaktiert und weist eine ausreichende Querschnittsfläche zur Leitung hoher Ströme auf.

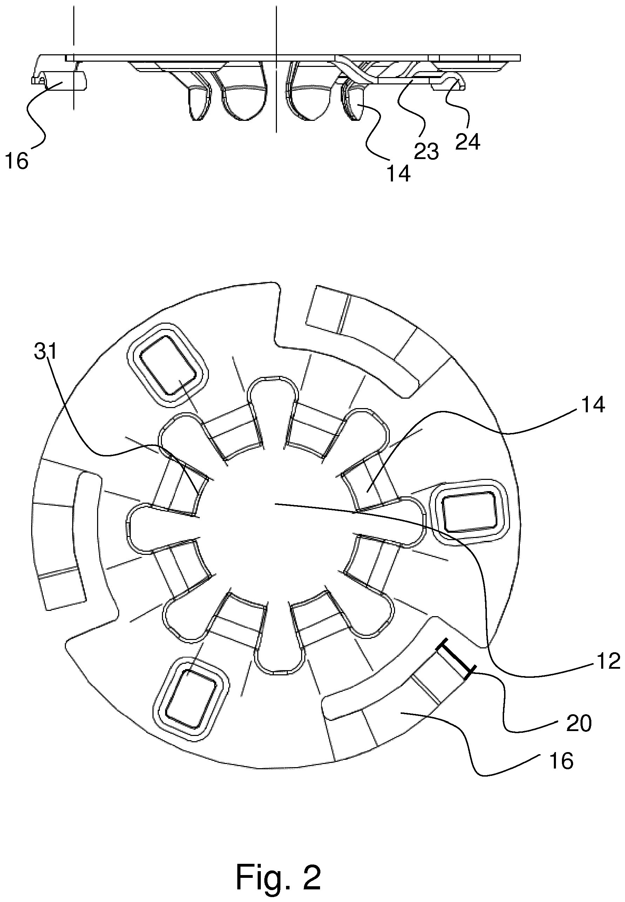

Unterhalb des Kontaktstiftes 1 ist die zweite Führung 4 dargestellt, die in dieser Ausführungsform als etwa kreisscheibenförmiger Körper mit einer zentralen Öffnung 12 ausgebildet ist. In Einbaulage durchsetzt der Kontaktstift 1 diese Öffnung 12 und wird an seiner Mantelfläche von den Federkontaktarmen 14 unter Federkraft berührt. Diese Federkontaktarme 14 weisen mit ihren freien Enden etwa in Richtung des Mittelpunktes der zentralen Öffnung 12 und definieren so zwischen sich einen Kreis 31 (Fig. 2), durch den der Kontaktstift 1 in Einbaulage hindurchtritt. Da dieser Kreis 31 einen kleineren Durchmesser als der Durchmesser des Kontaktstiftes 1 hat und die Federkontaktarme 14 aus der Ebene der zweiten Führung 4 in einem Winkel hinausragend sind, ergibt sich eine Federkraft in Richtung auf die Mantelfläche des Kontaktstiftes 1, ein federnden Kontakt ist ermöglicht. Die Federkontaktarme 14 können aus einem anderen Material als der restliche Körper der zweiten Führung 4 ausgebildet sein, beispielsweise aus Gründen einer besseren Biegesteifigkeit, einer höheren Federkraft oder dergleichen. Sie können erfindungsgemäß auch aus demselben Material bestehen. Ebenfalls zu erkennen sind drei zueinander in gleichem Winkelabstand angeordnete und in Richtung auf die erste Führung 3 orientierte Sicken 21 sowie dazwischen drei ebenfalls zueinander im gleichen Winkelabstand angeordnete Eingriffsnasen 16, die jeweils in eine Ausnehmung 25 hineinragen. Die radiale Breite 20 der Eingriffsnasen 16 ist geringer als die der Ausnehmung 25. Diese Eingriffsnasen 16 dienen zum Umgreifen der ersten Führung 3. Sie entspringen im Bereich des radial auswärtigen Randes 15 in der Ebene, die von der Zylinderscheibe der zweiten Führung 4 definiert ist und verlaufen in Umfangsrichtung. Sie weisen einen zur Ebene geneigten Abschnitt 22 auf, der in einen zur Ebene parallelen Abschnitt 23 übergeht. Jede Eingriffsnase 16 endet in einem von der Ebene weggekrümmten Abschnitt 24, wobei der Scheitelpunkt der Krümmung zwischen der Ebene der zweiten Führung 4 und derjenigen Ebene liegt, in der die parallelen Abschnitte 23 aller Eingriffsnasen 16 liegen. Hierdurch wird eine Art Feder gebildet, die einen innigen Kontakt von erster zu zweiter Führung 3, 4 sicherstellt. Die zweite Führung 4 ist aus Metall gefertigt und als StanzBiegeteil hergestellt.

Darunter ist die erste Führung 3 dargestellt. Die drei Bauteile von Fig. 1 sind also in der Anordnung dargestellt, in der sie später ineinander montiert werden. Die Führung 3 weist wie die zweite Führung 4 eine Kreisscheibe 9 als Hauptfläche auf, wobei die Kreisscheibe 9 eine erste zentrale Öffnung 5 aufweist, deren Durchmesser größer als die der zweiten zentralen Öffnung 12 der zweiten Führung 4 ist. In einem radial auswärtigen Bereich sind drei, in gleichem Winkelabstand äquidistant zueinander angeordnete, Öffnungen 6 vorgesehen. In den Bereichen 7 zwischen diesen radial auswärts liegenden Öffnungen 6 sind Sicken 8 angeordnet, die etwas größer als die Sicken 21 der zweiten Führung 4 ausgebildet sind. Beide Sickentypen 8, 21 weisen hier in entgegengesetzte Richtungen, können aber auch in dieselbe Richtung weisen, so dass in montiertem Zustand die Sicken 21 der zweiten Führung 4 in die Sicken 8 der ersten Führung 3 hineinragen und somit beide Führungen in Bereich der Sicken 8, 21 formschlüssig aneinander anliegen. Gleichzeitig wird so die Kontaktfläche beider Führungen 3, 4 im Vergleich zu einem sickenfreien Zustand erhöht. Dargestellt ist jedoch eine andere Ausgestaltung, bei der nämlich die Sicken 8 der ersten Führung 3 entgegengesetzt zu den Sicken 21 der zweiten Führung 4 ausgeprägt sind. Da sie somit nach unten geöffnet sind, stellen sie hierdurch einen Aufnahmeraum für die nach oben gebogenen Abschnitte 24 der Eingriffsnasen 16 dar und führen ebenfalls zu einem Formschluß. Durch diese Orientierung ist gleichzeitig ein weiterer Anschlag gebildet, da die Sicken 21 der zweiten Führung 4 mit ihren Rändern gegen die Ränder der Sicken 8 der ersten Führung 4 stoßen, wenn die zweite Führung 4 eine Rotationsbewegung relativ zu dieser ausführt. Da der Durchmesser der ersten Führung 3 größer als der der zweiten Führung 4 ist, kann sich diese relativ zu der ersten Führung 3 in zwei Richtungen beliebig horizontal bewegen, ohne aus deren überdeckter Fläche hinauszutreten. Insbesondere kann die zweite Führung 4 entlang der radialen Ausdehnung der radial auswärtigen Öffnungen 6 verschoben werden, die gleichzeitig auch zwei Anschläge für die zweite Führung 4 bilden und somit deren maximale Bewegbarkeit begrenzen. Dadurch, dass die Eingriffsnasen 16 kreisumfänglich verlaufen, kann die zweite Führung 4 auch eine rotatorische Bewegung im Verhältnis zur ersten Führung 3 ausführen, ohne dass die Eingriffsnasen 16 außer Eingriff gerieten. Der hierfür zur Verfügung stehende Winkel wird durch die umfängliche Länge der Eingriffsnasen 16 begrenzt. Das heißt, auf einer Seite durch den geneigten Abschnitt 22, der an den Rand der radial auswärtigen Öffnung 6 stößt. Die erste Führung 3 weist Befestigungslaschen 11 auf, die äquidistant um den Umfang des Randes 10 angeordnet sind und radial auswärts weisen. Die Höhe des Randes 10 definiert zusammen mit der Weite der Kreisscheibe 9 den Raum, in dem sich die zweite Führung 4 verschieblich bewegen kann.

Der **Fig. 2** ist in Seitenansicht und Aufsicht die vertikale Erstreckung der zweiten Führung 4 zu entnehmen. Die Enden der Federkontaktarme 14 ragen aus der Ebene der Hauptfläche hinaus und weisen in Aufsicht in Richtung des Mittelpunktes der zweiten zentralen Öffnung 12. Wie bereits erläutert, definieren sie mit ihren Enden einen Kreis 31, der einen kleineren Durchmesser als der Kontaktstift 1 aufweist. Der Aufsicht ist weiter die radiale Breite 20 der Eingriffsnasen 16 zu entnehmen. Der Seitenansicht sind die Parallelität und die Beabstandung der Kreisscheibenebene und der parallelen Abschnitte 23 zu entnehmen. Gut zu erkennen ist weiter, dass der nach außen gekrümmte Abschnitt 24 mit seinem Scheitelpunkt dichter an der Ebene der Kreisscheibe liegt und somit ebenfalls einen Federkontakt herstellt. Durch das Hinaustreten der Federkontaktarme 14 aus der Ebene der Kreisscheibe durchsetzen diese im Betriebszustand der Erfindung die zentrale Öffnung 5 der ersten Führung 3 und stellen damit ein weiteres Eingriffselement dar.

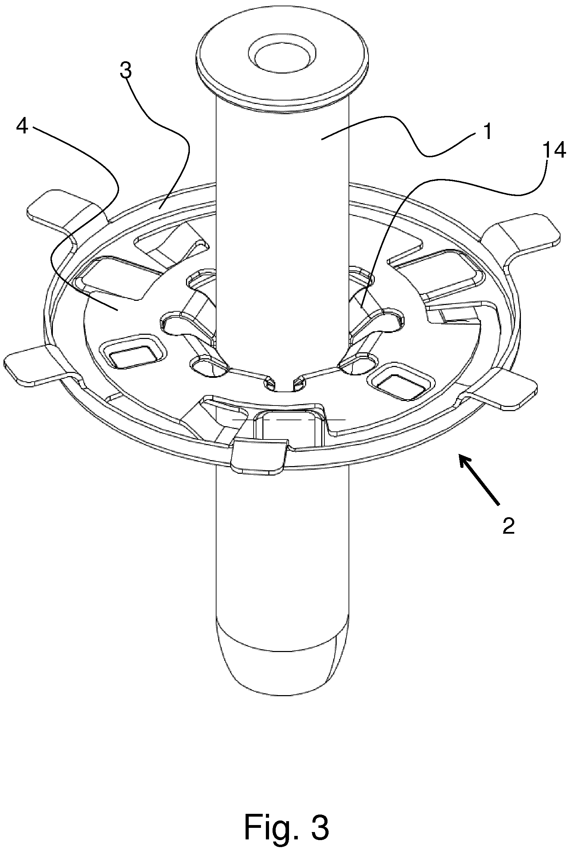

**Fig. 3** zeigt perspektivische Ansicht der Ausführungsform in Einbaulage. Der Kontaktstift 1 durchsetzt die zweite zentrale Öffnung 12 der zweiten Führung 4 und wird von deren Federkontaktarmen 14 unter Federkraft an seiner Mantelfläche flächig kontaktiert. Ein Kontaktstift 1 kann erfindungsgemäß auch mehr als zwei Kontaktstiftaufnahmen 2 durchsetzen, beispielsweise drei, vier oder mehr, sofern er ausreichend lang ausgebildet ist und die entsprechend gestapelten Bauteile dies geometrisch zulassen. Das erfindungsgemäße Zusammenwirken beider Führungen 3, 4 ist der Figur 3 in seiner Grundsätzlichkeit zu entnehmen: Diese erste Führung 3 definiert durch ihren größeren Durchmesser und die Höhe des Randes 10 den maximalen Bewegungsraum der an, bzw. in ihr angeordneten zweiten Führung 4. Obwohl die dargestellte Ausführungsform der ersten Führung 3 in Aufsicht eine Kreisscheibe ist, sind auch andere geometrische Formen der ersten Führung 3 denkbar, insbesondere Ovale, Polygone wie Dreieck, Viereck, Fünfeck, Sechseck oder höhere Polygone wie beispielsweise das nicht abschließend zu verstehende Dodekagon. Innerhalb dieser räumlich am Bauteil fixierten ersten Führung 3 ist verschieblich die zweite Führung 4 angeordnet. Diese weist ebenfalls eine zentrale Öffnung 12 auf, die im Bereich, insbesondere innerhalb, der ersten zentralen Öffnung 5 angeordnet ist. Da der Durchmesser der zweiten zentralen Öffnung 12 kleiner als der Durchmesser der ersten zentralen Öffnung 5 ist, kann die zweite zentrale Öffnung 12 eine Bewegung innerhalb gewisser Grenzen ausführen, ohne die Fläche der ersten zentralen Öffnung 5 zu verlassen. Oder genauer, ohne dass in der Aufsicht auf beide Öffnungen 5, 12 die Randlinie der zweiten zentralen Öffnung 12 die Randlinie der ersten zentralen Öffnung 5 schneidet. Diese Anordnung ermöglicht mit großem Vorteil ein relatives Bewegen von Kontaktstift 1 und Kontaktstiftaufnahme 2 zueinander, beispielsweise eine Taumelbewegung des Kontaktstiftes 1. Da in Betriebslage sowohl der Kontaktstift 1 als auch die erste Führung 3 jeweils an einem, wenn auch unterschiedlichen, Bauteil festgelegt sind, ermöglicht das Vorsehen einer zweiten Führung 2 wirkend zwischen Kontaktstift 1 und erster Führung 3 ein relatives Bewegen der beiden festgelegten Teile zueinander, indem die zweite Führung 4 ihre relative Lage zur ersten Führung 3 ändert, ohne den Kontakt zum Kontaktstift 1 zu verlieren. Die den Kontaktstift 1 kontaktierenden Federkontaktarme 14 der zweiten Führung 4 bleiben also kräftefrei und damit unbeeinflusst, wenn sich die Lage von Kontaktstift 1 zu erster Führung 3 ändert.

Die Erfindung trennt also die Funktionen von Kontaktieren des Kontaktstiftes 1 und Führen in der Kontaktstiftaufnahme 2 in zwei Bauteile. Der elektrische Kontakt zwischen erster Führung 3 und zweiter Führung 4 wird über das flächige Aufliegen der aneinander hergestellt, insgesamt also vom Kontaktstift 1 über die Federkontaktarme 14 der zweiten Führung 4 zur Fläche der ersten Führung 3, insbesondere zu den Bereichen 7 zwischen den radial auswärtigen Öffnungen 6 der ersten Führung 3, und schließlich über die Befestigungslaschen 11 in das nicht dargestellte Bauteil, beispielsweise eine Leiterplatte oder eine Stromschiene.

Die zweite Führung 4 ist also an der ersten Führung 3 geführt und kann relativ zu dieser eine Bewegung ausführen, die sowohl eine radiale als auch eine entlang des Kreisumfanges orientierte Komponente haben kann. Dies resultiert in der Ermöglichung einer Taumelbewegung des beide Führungen 3, 4 im Betriebszustand durchsetzenden Kontaktstiftes 1. Hierdurch bleibt dieser immer in Kontakt mit den Federkontaktarmen 14 der zweiten Führung 4 und diese wiederum immer in Flächenkontakt zur ersten Führung 3, die ihrerseits wiederum immer im Kontakt zum Bauteil steht.

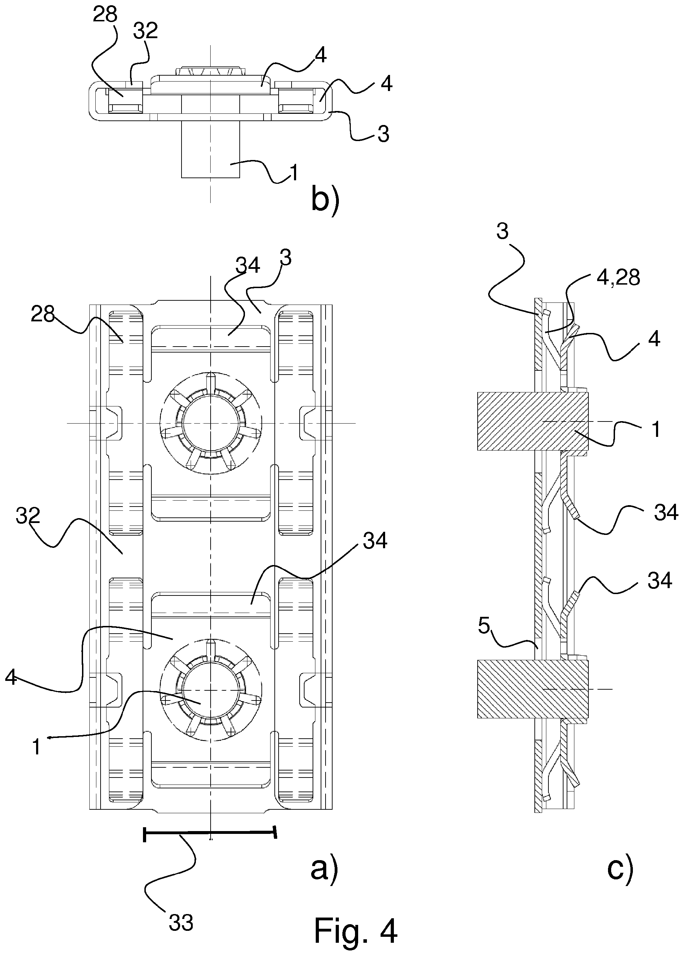

**Fig. 4a****-c** zeigt eine weitere Ausführungsform der Erfindung in Untersicht (4a), Seitenansicht (4b) und geschnittener Seitenansicht (4c).

Bei dieser Ausführungsform ist die erste Führung 3 als in Seitenansicht u-förmiges Bauteil mit einwärts aufeinander zuweisend umgelegten Enden 32 ausgebildet. Ein Aufnahmeraum für die zweite Führung 4 wird demnach durch den Abstand dieser Enden 32 von der Hauptfläche der ersten Führung (Höhe) und von der Breite und Länge der Grundfläche der ersten Aufnahme (Grundfläche) definiert. Im Bereich der umgebogenen Schenkel wird gleichzeitig ein Umgriff gebildet, der als Eingriffsmittel ein korrespondierend geformtes Eingriffsmittel der zweiten Führung 4 umgreift, nämlich ein Federelement 28. Der Abstand der beiden aufeinander zuweisenden Enden 32 definiert einen Kanal 33 mit einer Kanalweite. Zu dieser Kanalweite korrespondierend ist ein Eingriffsmittel 26 der zweiten Führung 4 gebildet, nämlich in Richtung von der ersten Führung 3 weg gerichtete aufgebogene Enden 34, die aus der Ebene herausragen, in denen die beiden aufeinander zuweisenden Enden 32 liegen. Die Breite dieser Enden 34 ist geringer als die Kanalweite. Hierdurch ergibt sich eine Verschiebbarkeit der zweiten Führung im Maße der Breitendifferenz, nämlich soweit, bis die Enden 34 mit ihren Schmalseiten an die Kanalwand stoßen. Dies zeigt sich auch in der Aufsicht 4a, wonach die Breite der zweiten Führung 4 zwischen zwei Federelementen 28 geringer ist als die Breite der Grundfläche der ersten Führung 3. Eine zweite Verschiebungsrichtung der zweiten Führung 4 ergibt sich entlang der Längsachse der ersten Führung 3, so dass auch bei dieser Ausführungsform eine horizontale Verschiebbarkeit in einer Ebene in zwei Richtungen der zweiten in der ersten Führung ermöglicht ist und ein beide durchsetzender Kontaktstift 1 daher eine Taumelbewegung relativ zu der ersten Führung 3 ausführen kann. In dieser Ausführungsform sind einer ersten Führung 3 zwei zweite Führungen 4 zugeordnet, es können erfindungsgemäß jedoch auch mehr als zwei, drei oder vier sein, insbesondere auch zweireihig oder mehrreihig angeordnete zweite Führungen 4, sofern die erste Führung 3 entsprechende Eingriffsmittel zur Verfügung stellt. Dies gilt grundsätzlich auf für die erste Ausführungsform, bei der die Form der ersten Führung 3 entsprechend anzupassen ist und die dann entsprechend ebenfalls mehr als eine zentrale Öffnung 5 aufweisen würde. Es ist auch erfindungsgemäß, mehrere zentrale Öffnungen 12 in der zweiten Führung 4 vorzusehen. Dies würde dazu führen, dass die diese durchsetzenden Kontaktstifte 1 dann nur mehr dieselbe Bewegung ausführen könnten und nicht voneinander unabhängige Taumelbewegungen. Je nach zu kontaktierendem Bauteil und dessen relative Bewegungen während des Betriebes kann das jedoch gewünscht sein.

Die Erfindung ermöglicht also eine Ausgleichsbewegung des Kontaktstiftes zu einer Bewegung der kontaktierten Bauteile bei deren Lageveränderung aufgrund geänderter Betriebsbedingungen aufgrund einer in einer Ebene ermöglichten Verschiebbarkeit einer zweiten Führung gegen eine erste, am Bauteil festgelegte Führung. Hierbei sind an beiden Führungen eine oder mehrere, konstruktiv und funktional genau auf einander abgestimmte Eingriffsmittel vorgesehen, die ineinander eingreifend eine sichere Kontaktierung ermöglichen und vorzugsweise neben form- auch kraftschlüssige Verbindungen zwischen den beiden Führungen ermöglichen.

### BEZUGSZEICHENLISTE

- 1: Kontaktstift
- 2: Kontaktstiftaufnahme
- 3: erste Führung
- 4: zweite Führung
- 5: erste zentrale Öffnung
- 6: radial auswärtige Öffnung
- 7: Bereich
- 8: Sicke
- 9: Kreisscheibe
- 10: Rand
- 11: Befestigungslasche
- 12: zweite zentrale Öffnung
- 13: Zentrum
- 14: Federkontaktarm
- 15: Radial auswärtiger Rand
- 16: Eingriffsnase
- 17: Höhe
- 18: radialer Längenunterschied

- 20: radiale Breite
- 21: Sicke
- 22: geneigter Abschnitt
- 23: paralleler Abschnitt
- 24: nach außen gekrümmter Abschnitt
- 25: Ausnehmung

- 28: Federelement
- 29: Einlaufschräge
- 30: Andruckfläche
- 31: Kreis
- 32: Ende
- 33: Kanal
- 34: aufgebogenes Ende

## Patentansprüche

1. Vorrichtung zur Leistungskontaktierung, aufweisend einen Kontaktstift (1) und mindestens eine von diesem im Betriebszustand durchsetzte Kontaktstiftaufnahme (2), wobei die Kontaktstiftaufnahme (2) eine, im Betriebszustand an einem Bauteil festgelegte, erste Führung (3) und eine, leitend mit der ersten verbundene, zweite Führung (4) aufweist, wobei die zweite Führung (4) verschieblich an der ersten Führung (3) angeordnet ist und wobei der Kontaktstift (1) im Betriebszustand mindestens die zweite Führung (4) leitend kontaktierend ist, wobei die erste und die zweite Führung (3, 4) jeweils eine zentrale Öffnung (5, 12) aufweisen, die im Betriebszustand jeweils von dem Kontaktstift (1) durchsetzt sind, **dadurch gekennzeichnet, dass** erste und zweite Führung (3, 4) zueinander korrespondierend ausgebildete Eingriffsmittel aufweisen.

2. Vorrichtung nach Anspruch 1, **dadurch gekennzeichnet, dass** die Eingriffsmittel der ersten Führung (3) als eine oder mehrere, insbesondere drei, radial auswärts liegende Öffnungen (6) ausgebildet sind, vorzugsweise umfänglich gleichbeabstandete Öffnungen (6), und/oder als Sicken (8) im Bereich (7) zwischen den radial auswärtigen Öffnungen (6) und/oder als Umgriffe.

3. Vorrichtung nach einem der vorhergehenden Ansprüche, **dadurch gekennzeichnet, dass** die erste Führung (3) als Kreisscheibe (9) mit einem dazu gewinkelten Rand (10) ausgebildet ist, insbesondere mit einer Mehrzahl vom Rand (10) radial auswärts gerichteten und zur Ebene der Kreisscheibe (9) überwiegend parallel orientierten Befestigungslaschen (11) ausgebildet ist.

4. Vorrichtung nach einem der vorhergehenden Ansprüche, **dadurch gekennzeichnet, dass** die zweite Führung (4) eine Mehrzahl, zu einem Zentrum (13) der zentralen Öffnung (12) gerichteter Federkontaktarme (14) aufweist und wobei die zweite zentrale Öffnung (12) kleiner als die erste zentrale Öffnung (5) ausgebildet ist.

5. Vorrichtung nach einem der vorhergehenden Ansprüche, **dadurch gekennzeichnet, dass** die Eingriffsmittel der zweiten Führung (4) als eine zur Zahl der radial auswärtigen Öffnungen (6) der ersten Führung (3) in Zahl und Form korrespondierende Eingriffsnasen (16) ausgebildet sind, insbesondere am radial auswärtigen Rand (15) der zweiten Führung und/oder als zum Eingriff in die Sicken (8) der ersten Führung (3) korrespondierend geformte und angeordnete Sicken (21) ausgebildet sind und/oder als Federelemente (28).

6. Vorrichtung nach einem der vorhergehenden Ansprüche, **dadurch gekennzeichnet, dass** die Eingriffsnasen (16) einen Umgriff (17) für die Bereiche (7) der ersten Führung (3) bildend sind.

7. Vorrichtung nach einem der vorhergehenden Ansprüche, **dadurch gekennzeichnet, dass** die zweite Führung (4) als Kreisscheibe ausgebildet ist, insbesondere als im Vergleich zur ersten Führung (3) radial kürzere Kreisscheibe, wobei insbesondere eine Dicke der Kreisscheibe geringer ist als eine Höhe (17) des gewinkelten Randes (10) der ersten Führung (3).

8. Vorrichtung nach einem der Ansprüche 1 bis 9, **dadurch gekennzeichnet, dass** die erste und/oder die zweite Führung (3, 4) als überwiegend rechteckige Platte ausgebildet sind.

9. Vorrichtung nach einem der vorhergehenden Ansprüche, **dadurch gekennzeichnet, dass** die zweite Führung (4) in der ersten Führung (3) eine horizontale verschiebliche Bewegbarkeit aufweist, wobei die maximalen Auslenkungen der zweiten Führung (4) einem radialen Längenunterschied (18) von radialer Ausdehnung der auswärts liegende Öffnungen (6) und einer radialen Breite (20) der Eingriffsnasen (16) entsprechend sind.

## Claims

1. A device for electrical contacting, having a contact pin (1) and at least one contact pin socket (2) penetrated by said contact pin in an operating state, wherein the contact pin socket (2) has a first guide (3) which is fixed on a component in an operating state, and a second guide (4) conductively connected with the first, wherein the second guide (4) is displaceably arranged on the first guide (3) and wherein the contact pin (1) makes contact in a conductive manner with at least the second guide (4) in an operating state, wherein the first and second guides (3, 4) each have a central opening (5, 12) which in an operating state is penetrated by the contact pin (1), **characterized in that** the first and second guides (3, 4) have engagement means respectively corresponding to each other.

2. The device according to Claim 1, **characterized in that** the engagement means of the first guide (3) are designed as one opening or as a plurality of, in particular three, openings (6) that are located radially outward, preferably as openings (6) that are located equidistantly along the circumference, and/or designed as recesses (8) in the area (7) between the radially outward openings (6), and/or designed as clasps.

3. The device according to any one of the preceding claims, **characterized in that** the first guide (3) is designed as a circular disc (9) with an angled edge (10), in particular with a plurality of fastening tabs (11) directed radially outward from the edge (10) and oriented predominantly parallel to the plane of the circular disc (9).

4. The device according to any one of the preceding claims, **characterized in that** the second guide (4) has a plurality of spring contact arms (14) directed toward a center (13) of the central opening (12), wherein the second central opening (12) is designed smaller than the first central opening (5).

5. The device according to any one of the preceding claims, **characterized in that** the engagement means of the second guide (4) are designed as hooks (16) corresponding in number and shape to the plurality of radially outward openings (6) of the first guide (3), in particular at the radially outward edge (15) of the second guide, and/or are designed as recesses (21) correspondingly shaped and arranged for engaging with the recesses (8) of the first guide (3), and/or are designed as spring elements (28).

6. The device according to any one of the preceding claims, **characterized in that** the hooks (16) form a clasp (17) for the areas (7) of the first guide (3).

7. The device according to any one of the preceding claims, **characterized in that** the second guide (4) is designed as a circular disc, in particular as a circular disc with a smaller radius compared to the first guide (3), wherein in particular a thickness of the circular disc is less than a height (17) of the angled edge (10) of the first guide (3).

8. The device according to any one of Claims 1 to 9, **characterized in that** the first and/or the second guide (3, 4) are designed as predominantly rectangular plates.

9. The device according to any one of the preceding claims, **characterized in that** the second guide (4) is displaceable horizontally within the first guide (3), wherein the maximum displacement of the second guide (4) corresponds to a radial difference in length (18) of the radial expansion of the outwardly positioned openings (6) and a radial width (20) of the hooks (16).

## Revendications

1. Dispositif de mise en contact de puissance, comportant une tige de contact (1) et au moins un logement de tige de contact (2) traversé par celle-ci à l'état de fonctionnement, sachant que le logement de tige de contact (2) comporte un premier guidage (3) fixé à l'état de fonctionnement sur un composant et un deuxième guidage (4) relié en conduction au premier, sachant que le deuxième guidage (4) est disposé de façon mobile sur le premier guidage (3) et sachant que la tige de contact (1) est en contact conducteur à l'état de fonctionnement avec au moins le deuxième guidage (4), sachant que le premier et le deuxième guidage (3, 4) comportent respectivement une ouverture centrale (5, 12), qui sont traversées respectivement à l'état de fonctionnement par la tige de contact (1), **caractérisé en ce que** le premier et le deuxième guidage (3, 4) comportent des moyens d'engagement constitués correspondant les uns aux autres.

2. Dispositif selon la revendication 1, **caractérisé en ce que** les moyens d'engagement du premier guidage (3) sont constitués sous la forme d'une ou plusieurs, en particulier de trois ouvertures (6) situées radialement vers l'extérieur, de préférence des ouvertures (6) périphériquement équidistantes et/ou sous la forme de moulures (8) dans la zone (7) entre les ouvertures (6) radialement vers l'extérieur et/ou sous la forme de serrages enveloppants.

3. Dispositif selon l'une quelconque des revendications précédentes, **caractérisé en ce que** le premier guidage (3) est constitué comme un disque circulaire (9) avec un bord (10) recourbé à cet effet, en particulier avec une pluralité de languettes de fixation (11) orientées du bord (10) radialement vers l'extérieur et orientées principalement parallèles au plan du disque circulaire (9).

4. Dispositif selon l'une quelconque des revendications précédentes, **caractérisé en ce que** le deuxième guidage (4) comporte une pluralité de bras de contact à ressort (14) orientés vers un centre (13) de l'ouverture centrale (12) et sachant que la deuxième ouverture centrale (12) est constituée plus petite que la première ouverture centrale (5).

5. Dispositif selon l'une quelconque des revendications précédentes, **caractérisé en ce que** les moyens d'engagement du deuxième guidage (4) sont constitués comme des ergots d'engagement (16) correspondant en nombre et en forme au nombre des ouvertures (6) radialement vers l'extérieur du premier guidage (3), sont en particulier constitués sur le bord (15) radialement vers l'extérieur du deuxième guidage et/ou sous la forme de moulures (21) formées et disposées de façon correspondante pour engagement dans les moulures (8) du premier guidage (3) et/ou sous la forme d'éléments à ressort (28).

6. Dispositif selon l'une quelconque des revendications précédentes, **caractérisé en ce que** les ergots d'engagement (16) forment un serrage enveloppant (17) pour les zones (7) du premier guidage (3).

7. Dispositif selon l'une quelconque des revendications précédentes, **caractérisé en ce que** le deuxième guidage (4) est constitué sous la forme d'un disque circulaire, en particulier sous la forme d'un disque circulaire radialement plus court en comparaison au premier guidage (3), sachant en particulier qu'une épaisseur du disque circulaire est plus faible qu'une hauteur (17) du bord recourbé (10) du premier guidage (3).

8. Dispositif selon l'une quelconque des revendications 1 à 9, **caractérisé en ce que** le premier et/ou le deuxième guidage (3, 4) sont constitués sous la forme d'une plaque principalement rectangulaire.

9. Dispositif selon l'une quelconque des revendications précédentes, **caractérisé en ce que** le deuxième guidage (4) comporte dans le premier guidage (3) une mobilité de déplacement horizontale, sachant que les déviations maximales du deuxième guidage (4) correspondent à une différence longitudinale radiale (18) de l'extension radiale des ouvertures (6) situées vers l'extérieur et à une largeur radiale (20) des ergots d'engagement (16).
